# EUROPEAN PATENT APPLICATION

(11) **EP 4 528 238 A1**
(43) Date of publication of application: **26.03.2025**
(21) Application number: 24189309.8
(22) Date of filing: 18.07.2024
(51) Int. Cl.: G01K 1/08, G01K 13/024

(54) **TEMPERATURE MEASUREMENT ASSEMBLY, SUBSTRATE PROCESSING APPARATUS, METHOD OF PROCESSING SUBSTRATE, AND METHOD OF MANUFACTURING SEMICONDUCTOR DEVICE**

(30) Priority: 21.09.2023 JP 2023155812
(71) Applicant: Kokusai Electric Corporation, Tokyo 101-0045 (JP)
(72) Inventor: AKAO, Tokunobu, Toyama-shi, Toyama, 9392393 (JP)
(74) Representative: Bardehle Pagenberg Partnerschaft mbB Patentanwälte Rechtsanwälte

(57) **Abstract**

There is provided a technique that includes: a gas supply pipe (34) including therein a flow path through which a gas flows; at least one temperature sensor (33) including a temperature measurement gauge (38) disposed outside the gas supply pipe (34) ; and a protective tube (32) inside which the gas supply pipe (34) and the at least one temperature sensor (33) are disposed, wherein an outlet of the gas supply pipe (34) configured to eject the gas into the protective tube (32) is positioned higher than the at least one temperature sensor (33), and the gas descends via a gap between an outer wall of the at least one temperature sensor (33) and an inner wall of the protective tube (32).

## Description

### CROSS-REFERENCE TO RELATED APPLICATION

This application is based upon and claims the benefit of priority from Japanese P atent Application No. 2023-155812, filed on September 21, 2023, the entire contents of which are incorporated herein by reference.

### TECHNICAL FIELD

The present disclosure relates to a temperature measurement assembly, a substra te processing apparatus, a method of processing a substrate, and a method of manufactu ring a semiconductor device.

### BACKGROUND

In a method of manufacturing a semiconductor device, there are cases where a ve rtical substrate processing apparatus is used as an apparatus configured to form an oxid e film or a metal film on a substrate (hereinafter referred to as "wafer"). When generati ng a predetermined film on the wafer, the interior of a process chamber is heated to a pr edetermined temperature while supplying a process gas to the interior of the process ch amber. To maintain the interior of the process chamber at the predetermined temperat ure, a temperature sensor configured to detect the temperature, such as a thermocouple, is installed in the interior of the process chamber.

An example of thermocouples that are usable under a high-temperature environ ment is a tungsten-rhenium (WRe) sheathed thermocouple. The WRe thermocouple ma y be used at high temperatures but may not be used in an oxidizing atmosphere. The sh eathed thermocouple is configured such that a thermocouple and an insulator are insert ed into a metal sheath tube, the interior of the sheath tube is filled with an inert gas, and a sealing end of the sheath tube is sealed, thereby isolating the thermocouple from an ox idizing atmosphere.

However, under a high-temperature environment, substances that deteriorate the sheath tube, such as oxygen, are generated from materials constituting the process cham ber or deposited films. In a case where the sheath tube deteriorates, the substances suc h as oxygen may reach the interior of the sheath tube. As a result, a state in which the in side of the sheath tube is completely filled with an inert atmosphere is destroyed, leadin g to deterioration of the thermocouple. This may cause a decrease in an electromotive f orce of the thermocouple, or even disconnection of the thermocouple, resulting in inacc urate temperature measurement. In particular, in a case where the sheath tube is cover ed with a protective tube, there is a possibility of long-term exposure to released gases fr om the protective tube that were trapped inside the protective tube. Further, evaporatio n or gas emission from the sheath tube itself may lead to deterioration of the protective t ube or contamination of the process chamber.

### SUMMARY

Some embodiments of the present disclosure provide a technique that is capable of enabling stable temperature measurement for a long period under a high-temperatur e environment.

According to some embodiments of the present disclosure, there is provided a tec hnique that includes: a gas supply pipe including therein a flow path through which a ga s flows; at least one temperature sensor including a temperature measurement gauge dis posed outside the gas supply pipe; and a protective tube inside which the gas supply pip e and the at least one temperature sensor are disposed, wherein an outlet of the gas sup ply pipe configured to eject the gas into the protective tube is positioned higher than the at least one temperature sensor, and the gas descends via a gap between an outer wall of the at least one temperature sensor and an inner wall of the protective tube.

### BRIEF DESCRIPTION OF DRAWINGS

The accompanying drawings, which are incorporated in and constitute a part of t he specification, illustrate embodiments of the present disclosure.
FIG. 1 is a longitudinal cross-sectional view illustrating an example of a process f urnace according to some embodiments of the present disclosure.
FIG. 2 is a longitudinal cross-sectional view illustrating a temperature measurem ent assembly according to some embodiments of the present disclosure.
FIG. 3 is an enlarged longitudinal cross-sectional view of main components illust rating a temperature measurement assembly according to some embodiments of the pre sent disclosure and a vicinity of an installation region thereof.
FIG. 4 is an enlarged longitudinal cross-sectional view of main components illust rating a tip of a temperature measurement assembly according to some embodiments of the present disclosure.
FIG. 5 is a flowchart illustrating a method of processing a substrate according to s ome embodiments of the present disclosure.
FIG. 6A is a longitudinal cross-sectional view illustrating a modification of a temp erature measurement assembly according to some embodiments of the present disclosur e, and FIG. 6B is a bottom surface view of FIG. 6A.

### DETAILED DESCRIPTION

Reference will now be made in detail to various embodiments, examples of which are illustrated in the accompanying drawings. In the following detailed description, nu merous specific details are set forth in order to provide a thorough understanding of the present disclosure. However, it will be apparent to one of ordinary skill in the art that th e present disclosure may be practiced without these specific details. In other instances, well-known methods, procedures, systems, and components are not described in detail s o as not to obscure aspects of the various embodiments.

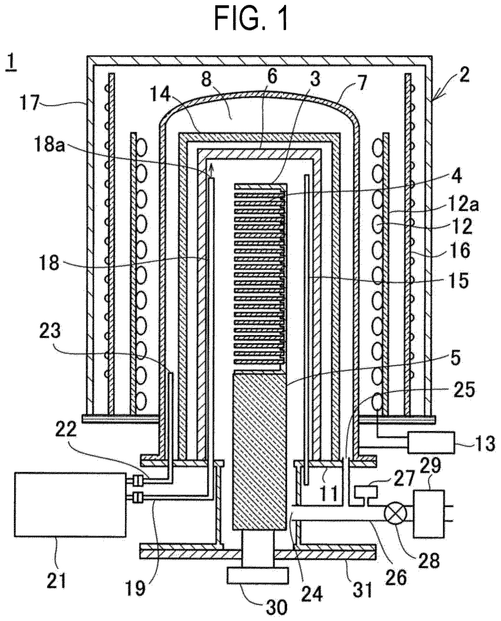

Hereinafter, some embodiments of the present disclosure will be described mainl y with reference to FIGS. 1 to 5. In addition, the drawings used in the following descripti on are schematic, and dimensional relationships, ratios, and the like of respective comp onents illustrated in the drawings may not match actual ones. Further, dimensional rela tionships, ratios, and the like of various components among plural drawings may not ma tch one another.

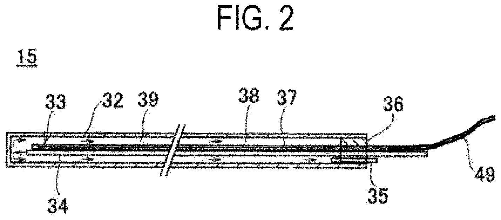

First, in FIG. 1, some embodiments according to the present disclosure will be de scribed. FIG. 1 illustrates a longitudinal cross-sectional view of a process furnace 2 in a substrate processing apparatus 1 according to the embodiments of the present disclosur e. In addition, FIGS. 2 to 4 illustrate the same configuration as the substrate processing apparatus 1 illustrated in FIG. 1, and the same reference numerals are given to compone nts substantially the same as those described in FIG. 1 and descriptions thereof are omit ted.

In addition, the substrate processing apparatus 1 according to the embodiments i s constituted as a so-called batch-type vertical SiC annealing apparatus configured to an neal a plurality of SiC substrates aligned in the vertical direction. By constituting the su bstrate processing apparatus 1 as a batch-type processing apparatus, it is possible proces s a great number of substrates to be processed at once, resulting in improved productivit y.

The substrate processing apparatus 1 is formed with, for example, the same confi guration as disclosed in the related art. The substrate processing apparatus 1 includes t he process furnace 2, and a boat 3 serving as a substrate holder is removably inserted int o the process furnace 2. The boat 3 is made of, for example, a heat-resistant material su ch as carbon graphite or SiC. The boat 3 is configured to hold a plurality of wafers 4, wh ich serve as substrates made of SiC or other materials, in such a state that the wafers 4 a re arranged in a horizontal posture and stacked along a vertical direction with centers of the wafers 4 aligned with one another. In addition, a boat insulator 5, which serves as a thermal insulator made of, for example, a heat-resistant material such as quartz or SiC, i s arranged at a lower side of the boat 3. The boat insulator 5 is configured to support th e boat 3 from below, making it difficult for heat from an induction target 6, which is des cribed below, to be transferred downward of the process furnace 2. When the boat 3 cha rged with the plurality of wafers 4 is loaded into the process furnace 2, heat treatment is performed.

Next, a configuration of the process furnace 2 included in the substrate processin g apparatus 1 will be described.

As illustrated in FIG. 1, the process furnace 2 includes a reaction tube 7, which is made of a heat-resistant material such as quartz or SiC and is formed in a cylindrical sha pe with a closed upper end and an open lower end. A reaction chamber 8 serving as a pr ocess chamber is formed in a cylindrical hollow space of the reaction tube 7. The reactio n chamber 8 is configured to accommodate therein the above-described boat 3, which h olds the wafers 4 serving as substrates made of SiC or other materials.

A manifold 11 is disposed concentrically with and below the reaction tube 7. The manifold 11 is made of, for example, stainless steel, and is formed in a cylindrical shape with open upper and lower ends. The manifold 11 is provided to support the reaction tu be 7 from below. An O-ring (not illustrated) serving as a seal is provided between the m anifold 11 and the reaction tube 7. The manifold 11 is supported by a holder (not illustra ted), thereby keeping the reaction tube 7 in a vertically installed state. A reaction contai ner is constituted by the reaction tube 7 and the manifold 11.

The process furnace 2 includes the induction target 6, which serves as a heating t arget to be heated by induction heating, and an inductive coil 12, which serves as an ind uctive heater, i.e., a magnetic-field generator. The induction target 6 takes the form of a cylinder made of, for example, a conductive heat-resistant material such as carbon, and i s provided to surround the boat 3 accommodated within the reaction chamber 8, i.e., to surround an accommodation region for the wafers 4. The induction target 6 may be for med in a cylindrical shape with open upper and lower ends, or may be formed in a cylin drical shape with a closed upper end and an open lower end. The inductive coil 12 is sup ported by a coil support 12a made of an insulating heat-resistant material and is provide d to surround an outer periphery of the reaction tube 7. The inductive coil 12 is configur ed to receive alternating current (AC) power from an AC power supply 13, for example, a t a frequency of 10 to 450 kHz and a power level of 10 to 200 kW. By an AC magnetic fie ld generated when an alternating current flows through the inductive coil 12, an inductio n current, i.e., an eddy current flows through the induction target 6, causing the inductio n target 6 to generate heat due to Joule's heat. With the heat generation of the inductio n target 6, the wafers 4 held in the boat 3 are heated to a predetermined processing tem perature, for example, 1500 to 2000 degrees C, due to a radiant heat from the induction target 6. In addition, to prevent a thermal damage, it is desirable to maintain the tempe rature of components below the process furnace 2, for example, at 200 degrees C or low er.

A thermal insulator 14 made of, for example, low-dielectric carbon felt is provide d between the reaction tube 7 and the induction target 6. The thermal insulator 14 is for med in a cylindrical shape with a closed upper end and an open lower end. Providing th e thermal insulator 14 may prevent the transfer of heat from the induction target 6 to th e reaction tube 7 or the outside of the reaction tube 7.

Further, a temperature measurement assembly 15 configured to detect a processi ng temperature is provided between the boat 3 holding the wafers 4 as described above and the induction target 6. The temperature measurement assembly 15 extends verticall y through the manifold 11 to protrude upward from the upper end of the boat 3. The te mperature measurement assembly 15 is electrically connected to a temperature controll er (not illustrated). The temperature controller regulates a state of supplying electric po wer from the AC power supply 13 to the inductive coil 12 based on temperature informat ion detected by the temperature measurement assembly 15, thereby controlling the proc essing temperature for the wafers 4 to be a desired temperature. A heater according to t he embodiments is primarily constituted by the induction target 6, the inductive coil 12, the AC power supply 13, and the temperature measurement assembly 15.

Further, an outer thermal-insulation wall 16 is provided outside the inductive coil 12 to surround the reaction chamber 8. The outer thermal-insulation wall 16 is formed with, for example, a water-cooled structure to prevent the transfer of heat from the react ion chamber 8 to the outside. Further, a magnetic shield 17 is provided outside the oute r thermal-insulation wall 16 to prevent a leakage of a magnetic field generated by the ind uctive coil 12 to the outside. The outer thermal-insulation wall 16 and the magnetic shie ld 17 may be constituted as an integrated structure.

A first gas nozzle 18 including a first gas supply port 18a, and the like are dispose d in the process furnace 2. The first gas nozzle 18 is located inside the induction target 6 and is vertically oriented between an accommodation region for the wafers 4 and the ind uction target 6. The first gas nozzle 18 is made of, for example, a heat-resistant material such as carbon graphite. The first gas supply port 18a is provided at an upper end (tip) o f the first gas nozzle 18. A downstream end of a first gas supply pipe 19 is connected to a n upstream end of the first gas nozzle 18. The first gas supply pipe 19 is provided to pass through the manifold 11. A gas supplier 21 is connected to an upstream end of the first g as supply pipe 19.

A second gas supply pipe 22 is vertically arranged outside the induction target 6 a nd between the thermal insulator 14 and the reaction tube 7. A second gas supply port 2 3 is provided at a downstream end of the second gas supply pipe 22. The second gas sup ply pipe 22 is provided to pass through the manifold 11. The gas supplier 21 is connecte d to an upstream end of the second gas supply pipe 22.

A first exhaust port 24 is opened at a sidewall of the manifold 11 facing the first ga s supply port 18a at the lateral side of and below the boat insulator 5, i.e., the accommod ation region for the wafers 4. Further, a second exhaust port 25 is opened, between the t hermal insulator 14 and the reaction tube 7, at a construction wall of the manifold 11 on which the reaction tube 7 is mounted. Branched upstream ends of an exhaust pipe 26 ar e connected to the first exhaust port 24 and the second exhaust port 25, respectively. Th e exhaust pipe 26 is provided with a pressure sensor 27 serving as a pressure detector, a n auto pressure controller (APC) valve 28 serving as a pressure regulator, and a vacuum pump 29 serving as a vacuum exhauster in this order from the upstream side. The press ure sensor 27, APC valve 28, and vacuum pump 29 are electrically connected to a pressu re controller (not illustrated). The pressure controller feedback-controls an opening stat e of the APC valve 28 based on pressure information measured by the pressure sensor 2 7, thereby controlling an internal pressure of the reaction chamber 8 to reach a predeter mined pressure at a predetermined timing.

By providing the first exhaust port 24 as described above, a gas supplied from the first gas supply port 18a into the reaction chamber 8, i.e., a process gas, flows downward in the reaction chamber 8, i.e., inside the induction target 6 through a region where the boat insulator 5 is provided, and is then discharged via the first exhaust port 24. At this time, the entirety of the wafers 4 are efficiently and uniformly exposed to the gas.

Further, by providing the second exhaust port 25 as described above, an inert gas such as nitrogen supplied from the second gas supply port 23 into the reaction chamber 8 acts as a purge gas, flows between the reaction tube 7 and the thermal insulator 14 and is then discharged from the second exhaust port 25. This prevents the process gas from entering a space between the reaction tube 7 and the thermal insulator 14, preventing ad hesion of unwanted products and others to surfaces thereof.

Further, the boat 3 is configured to be capable of being loaded into the reaction c hamber 8 (i.e., boat loading) and unloaded from the reaction chamber 8 (i.e., boat unloa ding) by an elevator (not illustrated). When the boat 3 is loaded into the reaction chamb er 8, an opening of the process furnace 2, i.e., a furnace opening, is airtightly closed by a sealing cap 31 via a seal such as an O-ring. In addition, a boat rotator 30 configured to s upport the boat insulator 5 passes through a center of the sealing cap 31, such that the b oat 3 is rotatable by the boat rotator 30.

Next, details of the temperature measurement assembly 15 will be described with reference to FIGS. 2 to 4. In addition, the temperature measurement assembly 15 is erec ted vertically inside the reaction tube 7, but is illustrated as extending horizontally in FI GS. 2 and 4.

The temperature measurement assembly 15 includes a protective tube 32, a sheat hed thermocouple 33 serving as a temperature sensor inserted into the protective tube 3 2, a gas supply pipe 34, a discharge pipe 35, and a seal 36 configured to seal the protecti ve tube 32. In addition, the sheathed thermocouple 33 may be positioned farther from a n axis (central axis) of the protective tube 32 than the gas supply pipe 34.

The protective tube 32 is formed in a cylindrical shape with a closed upper end an d an open lower end. A material of the protective tube is appropriately selected from var ious high-temperature ceramics and metals, including oxides such as graphite, Al₂O₃, an d MgO, carbides such as TaC, TiC, and SiC, and nitrides such as BN and AlN, depending on conditions such as processing temperature.

The sheathed thermocouple 33 is inserted into the protective tube 32 parallel to t he axis of the protective tube 32, so as to pass through the seal 36. The sheathed thermo couple 33 includes a sheath tube 37 and a thermocouple (TC) 38 serving as a temperatur e measurement gauge arranged inside the sheath tube 37. The sheath tube 37 is formed in a cylindrical shape with a closed upper end and an open lower end. The sheath tube 3 7 is made of a metal such as Ta or Mo. Further, the sheath tube 37 is filled with, for exa mple, an insulating powder such as magnesium oxide, and is thus configured to prevent the thermocouple 38 disposed therein from moving easily. Further, the sheath tube 37 i s filled with an inert gas, and a thermocouple cable extraction hole of the sheath tube 37 is sealed with glass or the like, such that the interior of the sheath tube 37 is sealed in a s tate that the interior is completely purged with the inert gas.

The gas supply pipe 34 is inserted into the protective tube 32 parallel to the axis o f the protective tube 32 so as to pass through the seal 36, thus extending and protruding to the vicinity of an inner wall upper end (tip) of the protective tube 32. Therefore, a spa ce (inner space) 32a with a predetermined size is formed between an upper end of the ga s supply pipe 34 and the inner wall upper end of the protective tube 32. Further, the gas supply pipe 34 includes a flow path formed therein and an outlet 34a formed at the tip, a nd is configured to be capable of supplying an inert gas such as argon gas (Ar gas) or nitr ogen gas (N₂ gas) upward into a space 32a inside the protective tube 32 via the outlet 34 a. In other words, the space 32a is formed at an upper side inside the gas supply pipe 34 , i.e., toward a gas ejection direction. The space 32a is provided to enable the inert gas d ischarged from the outlet 34a to change a flow direction thereof downward as smoothly as possible, and no solid object is disposed in that space.

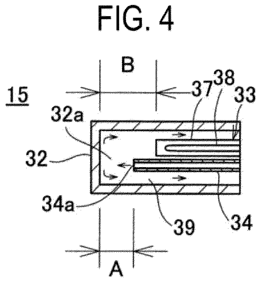

In addition, as illustrated in FIG. 4, the upper end (tip) of the gas supply pipe 34 extends and protrudes upward beyond an upper end (tip) of the sheathed thermocouple 33, and a lower end of the gas supply pipe 34 is connected to an inert gas supply apparat us (not illustrated). A dimension A from the upper end of the gas supply pipe 34 to the i nner wall upper end of the protective tube 32 is shorter than a dimension B from the up per end of the sheathed thermocouple 33 to the inner wall upper end of the protective tu be 32. Therefore, the sheathed thermocouple 33 and the gas supply pipe 34 are arrange d respectively such that the upper end of the gas supply pipe 34 is positioned higher tha n the upper end of the sheathed thermocouple 33. This ensures that the discharged iner t gas does not directly come into contact with the sheathed thermocouple 33, but is ther mally equalized with the protective tube 32 while flowing along an inner wall of the prot ective tube 32, and then comes into contact with the sheathed thermocouple 33.

The discharge pipe 35 is inserted into the protective tube 32 parallel to the axis of the protective tube 32, so as to pass through the seal 36. An upper end (tip) of the disch arge pipe 35 is positioned near the seal 36 and is configured to be capable of discharging the gas from the inside of the protective tube 32. In other words, the discharge pipe 35, which provides fluid communication between an atmosphere inside the protective tube 32 and an external atmosphere, is open near the seal 36 in a lower region of the protecti ve tube 32. Further, a diameter of the discharge pipe 35 is larger than a diameter of the gas supply pipe 34. This may prevent an increase in the internal pressure of the protecti ve tube 32.

The seal 36 is made of, for example, a heat-resistant adhesive or a heat-resistant r esin, and is constituted as a seal that airtightly seals an opening, i.e., the lower end of th e protective tube 32. The seal 36 isolates the atmosphere inside the protective tube 32, e xcluding the discharge pipe 35, from the external atmosphere.

The inert gas supplied to the gas supply pipe 34 is ejected from the outlet 34a to t he space 32a inside the protective tube 32, is deflected along the inner wall upper end of the protective tube 32 to descend through a gap 39 between an outer wall of the sheathe d thermocouple 33 and the inner wall of the protective tube 32, and is then discharged t o the outside via the discharge pipe 35.

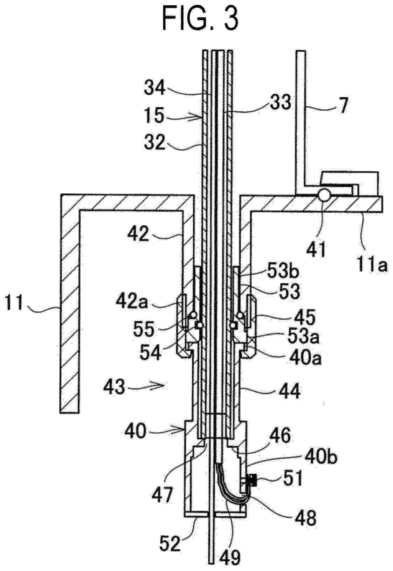

FIG. 3 illustrates an enlarged cross-sectional view illustrating the vicinity of an in stallation region of the temperature measurement assembly 15. The manifold 11 include s an annular flange 11a formed at the upper end to expand outward in the circumferenti al direction, and the reaction tube 7 is mounted on the flange 11a. An O-ring 41 is provid ed between the reaction tube 7 and the flange 11a. The O-ring 41 ensures airtightness be tween the reaction tube 7 and the flange 11a.

Further, a TC port 42 is formed in the flange 11a. The TC port 42 is formed in a c ylindrical shape in which the TC port 42 extends and protrudes downward parallel to th e axis of the reaction tube 7, and a threaded portion 42a is formed at the lower end of th e TC port 42.

The temperature measurement assembly 15 is held by a TC holder 43. The TC hol der 43 includes a casing 40, a cable extraction hole 48 serving as an exhauster, a termin al screw 51, and a sleeve 53 serving as a vacuum joint.

The casing 40 is formed in a substantially cylindrical shape, with an inner diamet er larger than an outer diameter of the protective tube 32. A cylindrical recess 44 is for med in the middle of an outer periphery of the casing 40, and a cap nut 45 is loosely fitte d into the recess 44 in a non-removable manner. The cap nut 45 is slidable vertically bet ween upper and lower ends of the recess 44. Further, an annular flange 40a is formed a t the upper end of the recess 44 to extend and protrude toward an outer peripheral side.

Inside the casing 40, an inner flange 46 is formed, and the inner flange 46 serves as a bonder extending and protruding toward a central side of the casing 40. The inner f lange 46 provides a hole 47 smaller than an inner diameter of the casing 40. A diameter of the hole 47 is larger than the inner diameter of the protective tube 32 but is smaller th an the outer diameter of the protective tube 32. Therefore, when the casing 40 holds the temperature measurement assembly 15, a lower surface of the protective tube 32 comes into contact with an upper surface of the inner flange 46. In addition, the protective tub e 32 and the inner flange 46 are bonded with an adhesive, which integrates the protectiv e tube 32 and the casing 40. Further, the sheathed thermocouple 33, gas supply pipe 34 , and discharge pipe 35, which pass through the seal 36, extend and protrude downward through the hole 47.

A cable extraction hole 48 is formed at a peripheral wall of the casing 40 below th e inner flange 46. As a wire of the temperature sensor, a thermocouple cable 49 extends and protrudes from a lower end of the sheathed thermocouple 33 and is drawn out of th e casing 40 through the cable extraction hole 48. Further, the cable extraction hole 48 a lso functions as a discharge port configured to discharge the inert gas discharged from t he discharge pipe 35 to the outside.

At the outer wall of the casing 40, a flat surface portion 40b parallel to the longitu dinal direction of the protective tube 32 is formed, and the terminal screw 51 is provided at the flat surface portion 40b. Providing the terminal screw 51 at the flat surface portio n 40b makes it easier to attach or detach the terminal screw 51. The terminal screw 51 f unctions as an exposed terminal electrically connected to the sheathed thermocouple 33 . An end of the thermocouple cable 49 extending and protruding from the cable extracti on hole 48 is detachably attached to the terminal screw 51. Further, a gauge (not illustra ted) capable of receiving electrical signals from the thermocouple 38 is connectable to th e terminal screw 51 via a cable (not illustrated). The cable connected to the terminal scr ew 51 and the gauge functions as a connector electrically connected to the sheathed ther mocouple 33.

A lower end opening of the casing 40 is closed by a holder cap 52 serving as a lid. In addition, a hole for the passage of the gas supply pipe 34 is formed at the holder cap 5 2, and the holder cap 52 closes the casing 40 with the gas supply pipe 34 passing thereth rough. Therefore, the holder cap 52 also functions as a support configured to support a 1 oad in a direction perpendicular to an axial direction of the gas supply pipe 34. Further, one end of the discharge pipe 35 passing through the seal 36 is open into the casing 40 b elow the inner flange 46, allowing fluid communication therebetween. Further, the inte rior of the casing 40 is purged with the inert gas discharged from the protective tube ₃₂ via the discharge pipe 35. The inert gas that purged the interior of the casing 40 is disch arged via the cable extraction hole 48.

The cylindrical sleeve 53 is provided at an upper side of the casing 40. The protec tive tube 32 is inserted through the sleeve 53, with the lower end of the protective tube 3 2 in contact with an upper end of the casing 40. Further, the sleeve 53 includes a large-diameter portion 53a and a small-diameter portion 53b with a smaller diameter than the large-diameter portion 53a. An outer diameter of the large-diameter portion 53a is larg er than an inner diameter of the TC port 42 but is smaller than an outer diameter of the TC port 42. An outer diameter of the small-diameter portion 53b is smaller than the inn er diameter of the TC port 42, allowing the small-diameter portion 53b to be inserted int o the TC port 42. Further, an O-ring 54, serving as a first airtight seal, is provided along the entire circumference of an inner wall of the large-diameter portion 53a, and an O-rin g 55, serving as a second airtight seal, is provided along the entire circumference of an u pper end of the large-diameter portion 53a.

When the protective tube 32 is inserted through the sleeve 53, the O-ring 54 is pr essed against an outer wall of the protective tube 32, ensuring an airtightness between t he sleeve 53 and the protective tube 32. Further, when the small-diameter portion 53b i s inserted into the TC port 42, the O-ring 55 is pressed between the large-diameter porti on 53a and the lower end of the TC port 42, ensuring an airtightness inside the sleeve 53 and an inside of the TC port 42. Therefore, an airtightness inside the TC port 42, i.e., th e reaction chamber 8, is ensured by the O-rings 54 and 55, which prevents leakage of an atmosphere in the reaction chamber 8 through the TC port 42.

When attaching the temperature measurement assembly 15 to the process furnac e 2, the temperature measurement assembly 15 is held by the casing 40 and the protecti ve tube 32 is inserted into the sleeve 53. In this state, the protective tube 32 and the sm all-diameter portion 53b of the sleeve 53 are inserted into the TC port 42 from below. F urther, the cap nut 45 is screwed to the threaded portion 42a formed at the outer periph eral wall of the TC port 42. By screwing the cap nut 45, the flange 40a is pulled upward, i.e., closer to the sleeve 53, by the cap nut 45, thereby pressing the sleeve 53, which is in contact with the flange 40a, against the TC port 42. As the sleeve 53 is pressed, an uppe r surface of the large-diameter portion 53a is pressed against a lower surface of the TC p ort 42, thereby airtightly closing the TC port 42 via the O-ring 55. The flange 40a and th e cap nut 45 function as an engager for engaging with the sleeve 53.

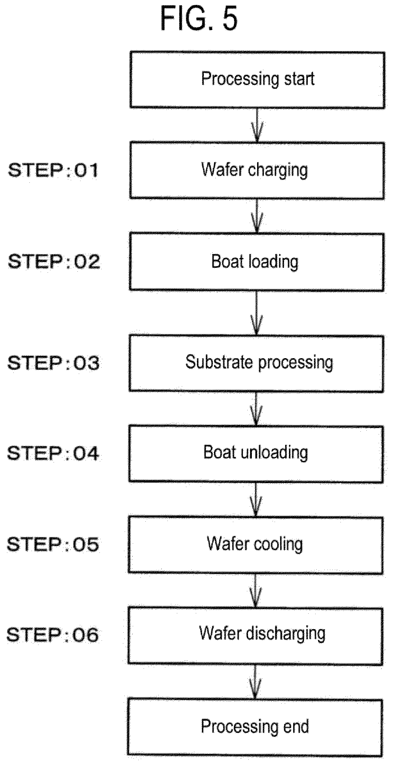

Next, a substrate processing for which the above-described substrate processing a pparatus 1 is used will be described with reference to the flowchart in FIG. 5. Herein, an example in which annealing is performed by supplying an argon (Ar) gas, serving as a pr ocess gas, into the reaction chamber 8 to remove oxygen from the wafer 4 will be describ ed. In addition, the processing temperature herein refers to a temperature of the wafer 4 or a temperature of the reaction chamber 8, and the processing pressure refers to an i nternal pressure of the reaction chamber 8. In addition, in the following description, an operation of each component constituting the substrate processing apparatus 1 is contro lied by a controller (not illustrated).

The following description begins from a state where the seal cap 31 is lowered by an elevator (not illustrated) and the boat 3 is unloaded from the reaction tube 7 (i.e., boa t unloading), such that the wafer 4 does not exist in the boat 3.

### (Wafer Charging and Boat Loading)

When a FOUP accommodating the wafer 4 is introduced into the substrate proces sing apparatus 1, the wafer 4 is transferred to the boat 3 by a carrier (not illustrated) (ST EP: 01). When the boat 3 is charged with a plurality of wafers 4 (i.e., wafer charging), th e seal cap 31 is raised by the elevator (not illustrated), and the boat 3 is then loaded insid e the induction target 6 within the reaction chamber 8 (i.e., boat loading), and the lower opening of the reaction tube 7 is airtightly closed (sealed) by the seal cap 31 (STEP: 02).

### (Pressure Regulation and Temperature Regulation)

The reaction chamber 8 is vacuum-exhausted, i.e., decompression-exhausted, by the vacuum pump 29. The atmosphere in the reaction chamber 8 flows linearly or subst antially linearly through the exhaust pipe 26 and is exhausted via the vacuum pump 29. After the internal pressure of the reaction chamber 8 is vacuum-exhausted, an Ar gas is supplied into the reaction chamber 8. A flow rate of the Ar gas is controlled to be a pred etermined flow rate by the gas supplier 21, and is supplied into the reaction chamber 8 v ia the first gas supply pipe 19 and the first gas nozzle 18 from the tip of the first gas nozzl e 18. Further, in parallel with the supply of Ar gas, i.e., in a state where the seal cap 31 cl oses the opening of the manifold 11, the gas supplier 21 supplies a purge gas whose flow rate is controlled to be a desired flow rate to a space between the reaction tube 7 and the thermal insulator 14 from the second gas supply port 23 via the second gas supply pipe 2 2. The purge gas is ejected upward, then diffused in the circumferential direction along the ceiling, descends along the circumferential surface, and is then discharged out of the reaction chamber 8 via the second exhaust port 25 and the exhaust pipe 26. The interna l pressure of the reaction chamber 8 is measured by the pressure sensor 27, and the APC valve 28 is feedback-controlled based on the measured pressure information to regulate the internal pressure to a predetermined pressure (state of vacuum).

To achieve a predetermined temperature of the wafers 4 in the reaction chamber 8, a predetermined AC power is supplied from the AC power supply 13 to the inductive c oil 12, which causes an inductive current to flow through the induction target 6 to raise t he temperature, such that the wafers 4 are heated from the periphery thereof by the ind uction target 6. Induction heating enables efficient heating of the wafers 4. At this time, a state of supplying electric power to the inductive coil 12 is feedback-controlled based o n temperature information detected by the sheathed thermocouple 33 to ensure that the entirety of the wafers 4 charged in the boat 3 exhibit a predetermined temperature distri bution. In addition, the rotation of the boat 3 and the wafers 4 is initiated by the boat ro tator 30.

In addition, in parallel with the supply of electric power to the inductive coil 12, a n inert gas is supplied into the protective tube 32 via the gas supply pipe 34. The inert g as is constantly supplied into the protective tube 32 during substrate processing, for exa mple. Alternatively, the supply of the inert gas into the protective tube 32 may be initiat ed when the temperature detected by the sheathed thermocouple 33 exceeds the ambien t temperature.

Supplying the inert gas creates an inert gas atmosphere in the protective tube 32, preventing deterioration of the sheath tube 37 and maintaining the inert gas atmosphere in the sheath tube 37, which prevents oxidation of the sheathed thermocouple 33. Furth er, by continuously performing the supply of the inert gas from the gas supply pipe 34 a nd the discharge of the inert gas from the discharge pipe 35, the atmosphere in the prote ctive tube 32 may be constantly replenished with new inert gas, ensuring maintenance o f the inert gas atmosphere.

### (Substrate Processing)

The wafer 4 is heated at a predetermined temperature for a predetermined time i n an Ar atmosphere. This activates ion-implanted impurities, or removes surface oxyge n, resulting in the production of an annealed wafer (STEP: 03).

### (Boat Unloading and Wafer Discharging)

After producing the annealed wafer, the supply of electric power to the inductive coil 12 is cut off, and the wafer 4 is cooled until the temperature thereof drops to a prede termined temperature. After the wafer 4 is cooled, the APC valve 28 is closed to return t he internal pressure of the reaction chamber 8 to atmospheric pressure. After that, the s eal cap 31 is lowered by the elevator (not illustrated), and the boat 3 is unloaded from th e reaction tube 7 (i.e., boat unloading) (STEP: 04).

After the boat 3 is unloaded, i.e., in a state where the seal cap 31 is not closing the opening of the reaction chamber 8, the wafer 4 and the boat insulator 5 are subjected to cooling (STEP: 05).

When the wafer 4 and the boat insulator 5 are cooled to a predetermined tempera ture, the processed wafer 4 charged in the boat 3 is accommodated in the FOUP by the c arrier (not illustrated), and the FOUP is unloaded out of the substrate processing appara tus 1 (STEP: S06), completing the substrate processing.

Processing conditions when the wafer 4 is Ar-annealed are exemplified as follows
Processing temperature (wafer temperature): 1500 to 1900 degrees C;
Processing pressure (internal pressure of the process chamber): 1 Pa to atmosph eric pressure;
Ar gas: 1 sccm to 5 SLM; and
N₂ gas: 1 sccm to 5 SLM.

By setting each processing condition to a value within each range, film formation may proceed appropriately. In addition, notation of numerical ranges such as "1500 to 1 900 degrees C" as described above refers that both lower and upper limits are included i n that range. For example, "1500 to 1900 degrees C" means "1500 degrees C or higher a nd 1900 degrees C or lower." The same applies other numerical ranges.

According to the embodiments of the present disclosure, one or more effects as d escribed below are obtained.

In the embodiments, the temperature measurement assembly 15 installed in the r eaction chamber 8 includes the protective tube 32, and the sheathed thermocouple 33 a nd the gas supply pipe 34 inserted into the protective tube 32. Therefore, the inert gas is continuously supplied into the protective tube 32 from the gas supply pipe 34 to continu ously replenish the interior of the protective tube 32 with the inert gas, enabling an inert gas atmosphere to be maintained in the protective tube 32. Further, even in a case wher e oxygen or impurities is volatilized from the protective tube 32 itself, they may be disch arged with the constantly supplied inert gas, thereby preventing deterioration of the she athed thermocouple 33, and prolonging a lifespan of the sheathed thermocouple 33. Thi s enables stable temperature measurement in the reaction chamber 8 for a long time.

In addition, heat movement in the reaction chamber 8 where the temperature is 1 500 degrees C or higher is predominantly governed by heat radiation rather than heat c onduction or heat transfer. Therefore, the sheathed thermocouple 33 may maintain res ponsiveness even in a case where the sheathed thermocouple 33 is not in contact with th e protective tube 32.

Further, there is no case where the sheathed thermocouple 33 is directly exposed inside the reaction chamber 8. Thus, even in a case where the sheathed thermocouple 3 3 deteriorates under a high-temperature environment, metal contamination of the wafer 4 may be prevented.

Further, since the upper end of the gas supply pipe 34 is positioned above the up per end of the sheathed thermocouple 33, the sheathed thermocouple 33 may be in the f low of inert gas from above. This more reliably ensures an inert gas atmosphere around the sheathed thermocouple 33, further prolonging the lifespan of the sheathed thermoco uple 33. Further, since the inert gas is made to come into contact with the sheathed ther mocouple 33 after being heated to a level equivalent to the temperature of the protective tube 32, the measurement temperature of the sheathed thermocouple 33 is not affected by the inert gas, resulting in improved temperature measurement accuracy.

Further, since the temperature measurement assembly 15 is held by the casing 40 and the seal 36 is not exposed to the outside, it is possible to prevent external forces app lied to the seal 36, preventing damage to the seal 36.

Further, the holder cap 52 is configured to close the casing 40 while allowing the gas supply pipe 34 to pass therethrough. In other words, the holder cap 52 is configured to restrict the movement of the gas supply pipe 34 in the circumferential direction. Ther efore, even in a case where an external force is applied to the gas supply pipe 34, the hol der cap 52 may adsorb the external force, preventing damage to the seal 36.

Further, the protective tube 32 and the casing 40 are bonded with an adhesive, cr eating an integrated structure. This ensures that the engager engaged with the sleeve 53 , i.e., the flange 40a and the cap nut 45 are integrated with connectors, i.e., the thermoco uple cable 49 and the terminal screw 51. Thus, damage to the thermocouple cable 49 du e to tension is prevented and replacing the thermocouple cable 49 is made easier.

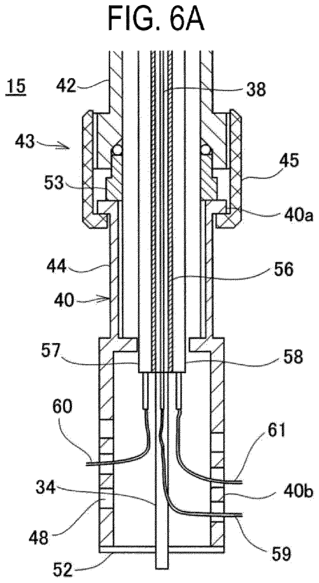

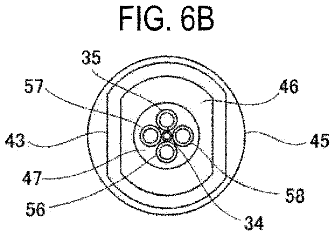

FIGS. 6A and 6B illustrate a modification of the embodiments of the present discl osure. In FIGS. 6A and 6B, components equivalent to those in FIGS. 1 to 4 are given the same reference numerals as FIGS. 6A and 6B, and descriptions thereof are omitted. In t he modification, the temperature measurement assembly 15 includes three sheathed the rmocouples 56, 57, and 58. The sheathed thermocouples 56, 57, and 58 and the dischar ge pipe 35 are inserted along the inner wall of the protective tube 32 at equal circumfere ntial intervals, for example, at intervals of 90 degrees as illustrated in FIG. 6B. Further, the gas supply pipe 34 is inserted, for example, along the axis of the protective tube 32, i nside the sheathed thermocouples 56, 57, and 58 and the discharge pipe 35. In addition , although not illustrated, similar to the sheathed thermocouple 33, the sheathed thermo couples 56, 57, and 58 each include a sheath tube and a thermocouple as a gauge arrang ed in the sheath tube.

Further, cable extraction holes 48 are formed at a plurality of locations (six locati ons in FIG. 6A) in a peripheral wall of the casing 40, and thermocouple cables 59, 60, an d 61 of the sheathed thermocouples 56, 57, and 58 are respectively configured to extend and protrude to the outside via any one cable extraction hole 48.

In the modification, the inert gas ejected from the upper end of the gas supply pip e 34 diffuses toward the central side or the outer peripheral side along the inner wall up per end of the protective tube 32, descends along the inner wall of the protective tube 32 , passes through the discharge pipe 35, and is then discharged from the cable extraction hole 48 in the same manner as the above-described embodiments.

Also in this modification, the same effects as the above-described embodiments a re obtained. Further, by providing the plurality of sheathed thermocouples 56, 57, and 5 8 along the inner wall of the protective tube 32, it is possible to perform stable temperat ure measurement regardless of rotated position thereof during installation.

According to the present disclosure in some embodiments, it is possible to achiev e stable temperature measurement for a long period under a high-temperature environ ment.

While certain embodiments are described above, these embodiments are present ed by way of example, and are not intended to limit the scope of the disclosures. Indeed, the embodiments described herein may be embodied in a variety of other forms. Furthe rmore, various omissions, substitutions and changes in the form of the embodiments de scribed herein may be made without departing from the spirit of the disclosures. The ac companying claims and their equivalents are intended to cover such forms or modificati ons as would fall within the scope and spirit of the disclosures.

## Claims

1. A temperature measurement assembly (15) comprising:
a gas supply pipe (34) including therein a flow path through which a gas flows;
at least one temperature sensor (33) including a temperature measurement gaug e (38) disposed outside the gas supply pipe (34); and
a protective tube (32) inside which the gas supply pipe (34) and the at least one t emperature sensor (33) are disposed,
wherein an outlet of the gas supply pipe (34) configured to eject the gas into the protective tube (32) is positioned higher than the at least one temperature sensor (33), a nd the gas descends via a gap between an outer wall of the at least one temperature sens or (33) and an inner wall of the protective tube (32).

2. The temperature measurement assembly (15) according to claim 1, further compri sing a gas discharge pipe (35) configured to discharge the gas from an inside of the prote ctive tube (32),
wherein a diameter of the gas discharge pipe (35) is larger than a diameter of the gas supply pipe (34).

3. The temperature measurement assembly (15) according to claim 1 or 2, wherein th e protective tube (32) includes an internal space in an ejection direction of the gas from the gas supply pipe (34).

4. The temperature measurement assembly (15) according to any one of claims 1 to 3 , wherein the at least one temperature sensor (33) includes a sheath tube (37), and the te mperature measurement gauge (38) is disposed inside the sheath tube (37).

5. The temperature measurement assembly (15) according to any one of claims 1 to 4 , further comprising a holder (43) including a bonder (46) bonded to a lower side of the protective tube (32), a connector including an exposed terminal electrically connected to the at least one temperature sensor (33), and an exhauster (48) configured to exhaust th e gas.

6. The temperature measurement assembly (15) according to claim 5, wherein the ho lder (43) further includes an engager configured to engage with a vacuum joint (53) conf igured to maintain an airtightness between the holder (43) and the protective tube (32).

7. The temperature measurement assembly (15) according to claim 4, further compri sing a gas discharge pipe (35) configured to discharge the gas from an inside of the prote ctive tube (32),
wherein the gas supply pipe (34), the sheath tube (37), and the gas discharge pip e (35) are arranged to extend inside the protective tube (32) in a longitudinal direction o f the protective tube (32), with each of the gas supply pipe (34), the sheath tube (37), an d the gas discharge pipe (35) partially exposed outside the protective tube (32), so that a space between: a lower side of the protective tube (32); and the gas supply pipe (34), she ath tube (37), and gas discharge pipe (35) is sealed with a sealing material.

8. The temperature measurement assembly (15) according to claim 5, wherein the ho lder (43) includes a casing (40) configured to accommodate a wire of the at least one te mperature sensor (33), and the connector is formed at the casing (40).

9. The temperature measurement assembly (15) according to claim 8, wherein one e nd of a gas discharge pipe (35) configured to discharge the gas from an inside of the prot ective tube (32) is open to enable fluid communication with an interior of the casing (40 ), the interior of the casing (40) is purged with the gas, the casing (40) includes a flat sur face portion (40b) parallel to a longitudinal direction of the protective tube (32), and the terminal is disposed on the flat surface portion (40b).

10. The temperature measurement assembly (15) according to any one of claims 1 to 9 , wherein the at least one temperature sensor (33) is positioned farther from a central ax is of the protective tube (32) than the gas supply pipe (34).

11. The temperature measurement assembly (15) according to claim 6, wherein the en gager includes a flange (40a) configured to come into contact with the vacuum joint (53) and a cap nut (45) configured to be screwed during installation to pull the holder (43) cl oser to the vacuum joint (53), and
wherein the cap nut (45) is loosely fitted into the holder (43) by the flange in a n on-removable manner.

12. The temperature measurement assembly (15) according to claim 4, wherein the at least one temperature sensor (33) includes a plurality of temperature sensors, each indiv idually accommodated in the sheath pipe.

13. A substrate processing apparatus (1) comprising:
a process container;
a heater provided to surround the process container;
a cylindrical heat generator disposed inside the process container to accommoda te a substrate, the heat generator capable of being raised in temperature by the heater;
a cylindrical thermal insulator (14) disposed between the process container and t he heat generator; and
a temperature measurement assembly (15) disposed inside the heat generator to extend in an axial direction of the heat generator,
wherein the temperature measurement assembly (15) comprises:
a gas supply pipe (34) including therein a flow path through which a gas f lows;
at least one temperature sensor (33) including a temperature measureme nt gauge (38) disposed outside the gas supply pipe (34); and
a protective tube (32) inside which the gas supply pipe (34) and the at lea st one temperature sensor (33) are disposed, and
wherein an outlet of the gas supply pipe (34) configured to eject the gas into the protective tube (32) is positioned higher than the at least one temperature sensor (33), a nd the gas descends via a gap between an outer wall of the at least one temperature sens or (33) and an inner wall of the protective tube (32).

14. A method of processing a substrate, comprising:
accommodating a substrate inside a cylindrical heat generator disposed in a proc ess container;
raising a temperature of the cylindrical heat generator by a heater provided to su rround the process container; and
controlling the heater based on a temperature measured by a temperature meas urement assembly (15) disposed inside the heat generator to extend in an axial direction of the heat generator,
wherein the temperature measurement assembly (15), which is used in the act of controlling, comprises:
a gas supply pipe (34) including therein a flow path through which a gas f lows;
at least one temperature sensor (33) including a temperature measureme nt gauge (38) disposed outside the gas supply pipe (34); and
a protective tube (32) inside which the gas supply pipe (34) and the at lea st one temperature sensor (33) are disposed, and
wherein the gas, which is ejected into the protective tube (32) from an outlet of t he gas supply pipe (34) positioned higher than the at least one temperature sensor (33), descends via a gap between an outer wall of the at least one temperature sensor (33) and an inner wall of the protective tube (32).

15. A method of manufacturing a semiconductor device comprising the method accor ding to claim 14.
